# EUROPEAN PATENT SPECIFICATION

(11) **EP 1 696 600 B1**
(45) Date of publication and mention of the grant of the patent: **28.07.2010**
(21) Application number: 05025831.8
(22) Date of filing: 25.11.2005
(51) Int. Cl.: H04L 7/02, H04L 7/00, H04L 7/033, G11C 7/10, G11C 11/4096, G06F 13/16

(54) **Prediction of an optimal sampling point for clock resynchronization in a source synchronous data channel**
Prädiktion eines Abtastzeitpunktes zur Taktresynchronisierung in einem mit einer Quelle synchronen Datenkanal
Prédiction d'un point d'échantillonnage optimal pour resynchronisation d'horloge dans un canal de données synchrone avec une source

(30) Priority: 24.02.2005 US 63969
(43) Date of publication of application: 30.08.2006
(73) Proprietor: Broadcom Corporation, Irvine, CA 92617 (US)
(72) Inventor: Jain, Sudhanshu, 95050 Santa Clara, CA (US)
(74) Representative: Jehle, Volker Armin

(56) References cited:
- US-A- 5 857 095
- US-A1- 2003 218 483
- US-A1- 2004 052 129
- US-B1- 6 509 762
- US-B1- 6 621 760
- GOGAERT S ET AL: "A skew tolerant CMOS level-based ATM data-recovery system without PLL topology" CUSTOM INTEGRATED CIRCUITS CONFERENCE, 1997., PROCEEDINGS OF THE IEEE 1997 SANTA CLARA, CA, USA 5-8 MAY 1997, NEW YORK, NY, USA,IEEE, US, 5 May 1997 (1997-05-05), pages 453-456, XP010235343 ISBN: 0-7803-3669-0

## Description

### BACKGROUND OF THE INVENTION

### Field of the Invention

The present invention relates to a network device in a data communications network and more particularly to a method of obtaining an optimal sampling of data obtained from an external source synchronous communication channel.

### Description of the Related Art

A data network may include one or more network devices, such as a Ethernet switching chip, each of which includes several modules that are used to process information that is transmitted through the device. Specifically, as data enters the device from multiple ports, it is forwarded to an ingress module where switching and other processing are performed on the data. Thereafter, data is transmitted to one or more destination ports through one or more units including a Memory Management Unit (MMU). The MMU provides access to one or more off-chip source synchronous memory devices, for example, an external Double Data Rate (DDR) memory. The network device typically generates a source synchronous clock that is provided with data during a write operation on the source synchronous memory device. The memory device then uses the clock to capture the data and perform the write operation. However, when the network device is performing a read operation from the memory device, the delay for data and clock from the memory device is indeterministic based on at least the trace lengths and process corner associated with the memory device. For example, if there is a fast process or slow process corner device, the delay from the memory device will vary. As such, the round trip delays for a read operation can vary greatly from chip-to-chip or board-to-board.

When a read operation is performed by the source synchronous memory device, the memory device returns data and clock. However, the clock phase from the source synchronous memory device can vary relative to the clock within the network device because the phases may shift. As is known, when the phases of the clock and data line up with each other, bit errors may occur and the network device cannot adequately sample data returned from the memory device.

Therefore, to obtain the least amount of error, a mechanism must be provided to sample the received data at a time when the data is most stable. Some source synchronous interfaces and some memory devices provide free running clocks. Current network devices typically sample the data multiple times to fmd out where the edges exist in relation to the internal clock in the network device. However, when there are no memory operations being performed by the source synchronous memory device, the received data is not changing. Hence, there are no edges/transitions for determining the optimal phase of the clock. Furthermore, even if memory operations are occurring, if the same data value is being continuously read, there will still be no transitions for determining the optimal phase of the clock.

To overcome the problems presented by source synchronous memory devices with free running clocks, some network devices use a first-in-first-out (FIFO) buffer to absorb difference between the memory controller clock in the network device and the clock generated by the source synchronous memory device. However, the use of the FIFO to absorb the differences between the clocks increases gate count which in turn increases circuit area. Use of a FIFO to realign clock phases also increases latency for received data.

US 6,509,762 describes a method and apparatus for capturing data read from a memory device that is aligned with respect to a clock strobe signal originating from the memory device, which has constraints with respect to a local clock signal supplied to the memory device. The apparatus includes a circuit for capturing the data read from the memory device relative to the clock strobe signal to produce captured read data, a circuit for latching the captured read data relative to a sample clock signal, and a circuit for measuring a phase difference between the sample clock signal and the clock strobe signal and adjusting a phase of the sample clock signal as a function of the phase difference.

According to the invention, there are provided a network device for determining an optimal sampling phase for source synchronous data as defined by independent claim 1, and a method for determining an optimal sampling phase for source synchronous data as defined by independent claim 6.

Further advantageous features of the invention are defined by the dependent subclaims.

Advantageously, the selecting means comprises means for obtaining votes from comparing the results of sampling using the plurality of phases to determine where a data transition edge is located.

Advantageously, the selecting means comprises means for changing the optimal phase when a count of votes from the plurality of phases passes a predetermined threshold.

Advantageously, the selecting means comprises a free running counter that is programmable to at least one threshold.

Advantageously, the selecting means further comprises means for taking a count on how many times a vote is asserted for each of the plurality of phases while the counter is running, wherein if a maximum count value is reached, the one of the plurality of phases associated with the count is selected as the optimal sampling phase.

Advantageously, the selecting means further comprises means for determining a optimal phase selection point to be at a predetermined distance from a sampling clock with is aligned with a data bit.

Advantageously, the selecting means further comprises means for changing the optimal sampling phase immediately upon detecting a more optimal sampling point.

Advantageously, the network device further comprises means for transmitting the clock to a phase shift generator and for transmitting an output from the phase shift generator to a circuit which creates the data pattern.

Advantageously, the network device further comprises means for sampling the data with the output of the phase shift generator, wherein the data is sampled at rising and falling edges of a clock outputted by the phase shift generator.

Advantageously, the selecting means comprises means for obtaining the data pattern and data previously sampled on a phase shifted clock.

Advantageously, the step of selecting comprises obtaining votes from comparing the results of sampling using the plurality of phases to determine where a data transition edge is located.

Advantageously, the step of selecting comprises changing the optimal phase when a count of votes from the plurality of phases passes a predetermined threshold.

Advantageously, the step of selecting comprises programming a free running counter to at least one threshold.

Advantageously, the step of selecting further comprises means taking a count on how many times a vote is asserted for each of the plurality of phases while the counter is running, wherein if a maximum count value is reached, the one of the plurality of phases associated with the count is selected as the optimal sampling phase.

Advantageously, the step of selecting comprises determining the optimal phase selection point to be at a predetermined distance from a sampling clock which is aligned with a data bit.

Advantageously, the step of selecting comprises changing the optimal sampling phase immediately upon detecting a more optimal sampling point.

Advantageously, the step of receiving comprises transmitting the clock to a phase shift generator and transmitting an output from the phase shift generator to a circuit which creates the data pattern.

Advantageously, the step of receiving comprises sampling the data with the output of the phase shift generator, wherein the data is sampled at rising and falling edges of a clock outputted by the phase shift generator.

### BRIEF DESCRIPTION OF THE DRAWINGS

The accompanying drawings, which are included to provide a further understanding of the invention and are incorporated in and constitute a part of this specification, illustrate embodiments of the invention that together with the description serve to explain the principles of the invention, wherein:
Figure 1 illustrates a network device in which an embodiment of the present invention may be implemented;
Figure 2a illustrates how memory read data is sampled by the network device;
Figure 2b aligned memory clock and read data;
Figure 3 illustrates sampling phases generated by the network device using multiple quadrature phases;
Figure 4 illustrates the steps in providing data for sampling from a memory clock domain to a network device clock domain.; and
Figure 5 illustrates the steps implemented in selecting an optimal sampling phase.

### DETAILED DESCRIPTION OF PREFERRED EMBODIMENTS

Reference will now be made to the preferred embodiments of the present invention, examples of which are illustrated in the accompanying drawings.

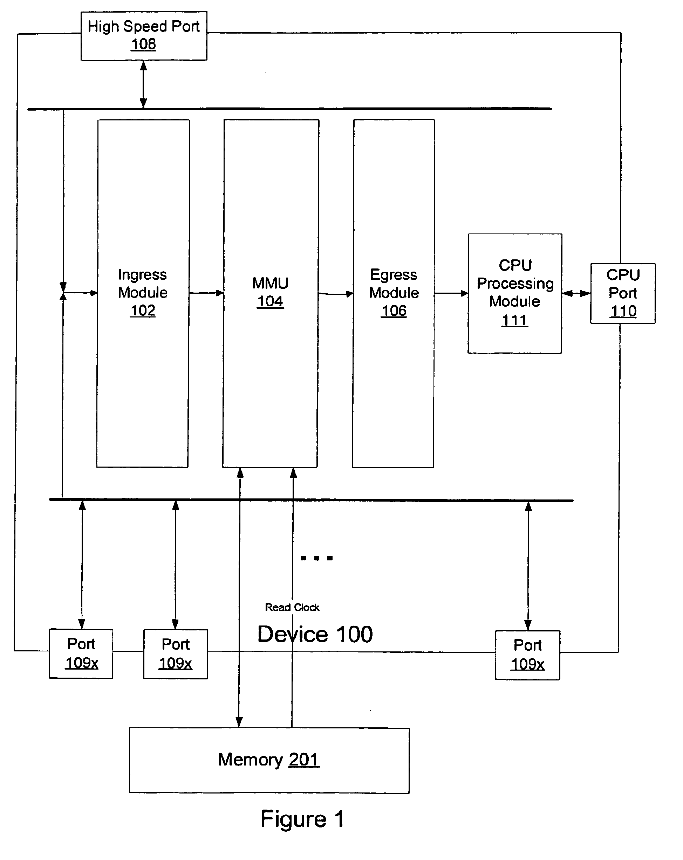

Figure 1 illustrates a network device, such as a switching chip, in which an embodiment the present invention may be implemented. Device 100 includes an ingress module 102, a MMU 104, and an egress module 106. Ingress module 102 is used for performing switching functionality on an incoming packet. The primary function of MMU 104 is to efficiently manage cell buffering and packet pointer resources in a predictable manner even under severe congestion scenarios. Egress module 106 is used for performing packet modification and transmitting the packet to an appropriate destination port.

Device 100 may also include one internal fabric high speed port, for example a HiGig port, 108, one or more external Ethernet ports 109a-109x, and a CPU port 110. High speed port 108 is used to interconnect various network devices in a system and thus form an internal switching fabric for transporting packets between external source ports and one or more external destination ports. As such, high speed port 108 is not externally visible outside of a system that includes multiple interconnected network devices. CPU port 110 is used to send and receive packets to and from external switching/routing control entities or CPUs. According to an embodiment of the invention, CPU port 110 may be considered as one of external Ethernet ports 109a-109x. Device 100 interfaces with external/off-chip CPUs through a CPU processing module 111, such as a CMIC, which interfaces with a PCI bus that connects device 100 to an external CPU.

Network traffic enters and exits device 100 through external Ethernet ports 109a-109x. Specifically, traffic in device 100 is routed from an external Ethernet source port to one or more unique destination Ethernet ports. In one embodiment of the invention, device 100 supports twelve physical Ethernet ports 109, each of which can operate in 10/ 100/ 1000 Mbps speed and one high speed port 108 which operates in either 10 Gbps or 12 Gbps speed.

In an embodiment of the invention, device 100 is built around a shared memory architecture, wherein MMU 104 provides access to one or more off-chip source synchronous memory devices, for example, an external Double Data Rate (DDR) memory device 201. In an embodiment of the invention, MMU 104 includes 4 DDR interfaces. During a write operation to device 201, network device 100 typically generates a source synchronous clock that is provided with data to the source synchronous memory device. Memory device 201 then uses the clock to capture the data and perform the write operation. However, when network device 100 is performing a read operation from memory device 201, the phase of the received clock and data is indeterministic and thus an optimal sampling phase must be derived.

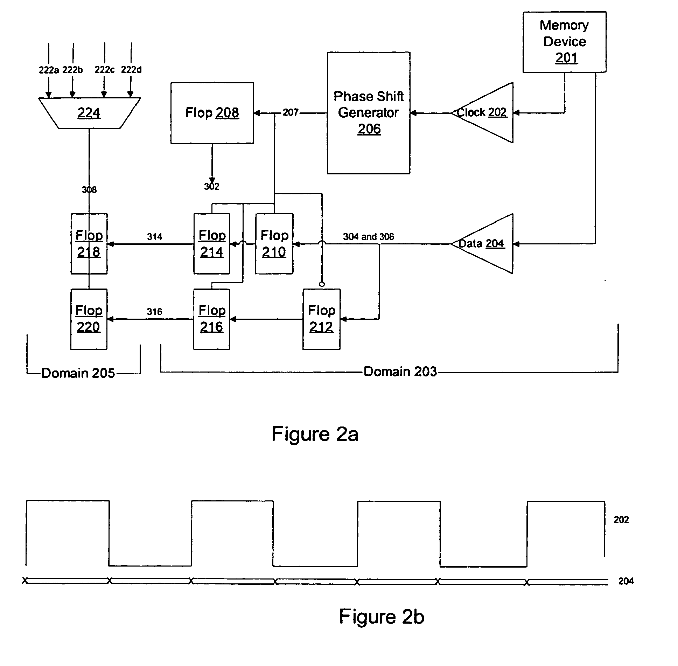

Figure 2a illustrates how memory read data is sampled by device 100 and timing is transferred from a clock domain 203 of the external memory to an internal clock domain 205 of device 100. As shown in figure 2, during a read operation in memory clock domain 203, memory device 201 generates a clock 202 and data 204 which is aligned as shown in figure 2b. This figure shows double data rate (DDR) data but the data could also be single data rate (SDR). However, the aligned clock 202 and data 204 do not provide an optimal sampling phase because clock edges do not occur when the data is most stable. Therefore, clock 202 is transmitted to a 90 degree phase shift generator 206, with offset control, which generates a 90 degree phase offset clock 207. Shift generator 206 may be a standard DLL or PLL generator. Clock 207 is then used to sample data 204, wherein clock 207 samples data 204 at the rising edge of clock 207 at flop 210 and samples data 204 at the falling edge of clock 207 at flop 212. Thereafter flops 214 and 216 are used to line up the data sampled at the rising and falling edges of the clock 207. Clock 207 is also transmitted to a divide-by-two circuit 208 which creates an alternating 1/0 data pattern that alternates every clock cycle. According to an embodiment of the invention, by using the same flip-flop cell in the divide-by-two operation as is used for the initial read data sample, the inventive system allows for better matching of delays and better determination of the optimal sampling phase. In an embodiment of the inventive system, memory 201 is not required to perform an operation in order for device 100 to obtain the transitions that are needed to determine an optimal phase for sampling data. The sampled results are then synchronized back into main clock domain 205 and are then fed into the state machine to decide which quadrature phase should be used to sample data from memory clock domain 203.

In an embodiment of the invention, along with the rise and fall data transmitted from memory device 201, device 100 also obtains the alternating 1/0 data pattern generated by circuit 208, wherein the alternating data pattern is in line with the aligned rise and fall data from flops 214 and 216. Device 100 then uses phases 222a-222d to multiply sample the alternating 1/0 data pattern multiple times to determine the optimal sampling phase. Thereafter, in core clock domain 205, device 100 provides multiple quadrature phases 222a-222d of a core clock. Phase 222a has a 0 degree offset from the core clock, phase 222b has a 270 degree offset from the core clock, phase 222c has a 180 degree offset from the core clock and phase 222d has a 90 degree offset from the core clock. According to one embodiment of the invention, device 100 generates four phases 222a-222d of the core clock. However, as is known to those of ordinary skill in the art, device 100 may generate more than four phases for better resolution.

In an embodiment of the inventive system, during sampling, device 100 ignores data 204 returned from memory device 201. Device 100 only samples the alternate 1/0 data pattern from clock 202, wherein the 1/0 data pattern provides a transition in every cycle. Since device 100 samples the alternating 1/0 data pattern, memory 201 is not required to perform an operation in order for device 100 to obtain the needed transitions that are sampled to determine an optimal phase for sampling data. As such, the inventive system eliminates the drifts that occur between phases when a transition does not occur every cycle, thereby causing the phase to be off. By producing a transition every cycle, the inventive system enables device 100 to constantly re-correct in order to determine the location of the optimal sampling phase.

Sampling of the alternating data pattern provides an advantage over directly sampling of the received clock or data in that it enables better phase match with the delays data from flops 214 and 216 to provide the most optimal sampling phase. The process corner delay variations of the alternating data pattern match the process corner delay variation of the data from flops 214 and 216. As is known to those skilled in the art, the clock returned from memory 201 typically includes jitter that blurs the edges. As such when a sample is obtained from near the edge, the data pattern may sometimes be a zero or a one, which is a non-optimal point for sampling data. Therefore, according to an embodiment of the invention, device 100 selects the optimal sampling phase that will produce the fewest sampling errors, that is, a sampling phase that is farthest away from the edges.

As mentioned above, device 100 operates without the need for any memory operations. As such, when device 100 is started, as long as a free running clock in memory 201 is executing, device 100 can determine the optimal sampling phase. Device 100 therefore relies only on the free running read strobe clock from external memory 210 and may run without a training sequence and remains locked even in the absence of memory operations. Since there is a transition every cycle, device 100 can realign every cycle, is insensitive to data patterns, and can tolerate infinite sequences of ones and zeros. Device 100 can also respond quickly to changes in phase of memory read strobe clocks since the sampled data has a guaranteed transition on every rising clock edge.

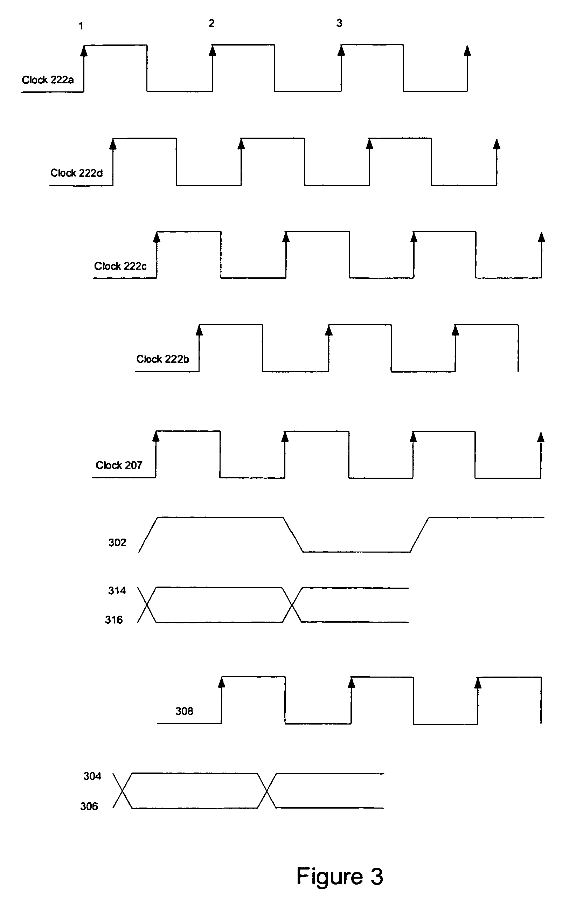

Figure 3 illustrates sampling phases generated by device 100 using phases 222a-222d. According to the inventive system, as illustrated in figure 3, the 90 degree shifted clock 207 was used to create an alternating 1/0 data pattern 302 which is then double-flop sampled with multiple 90 degree shifted quadrature phases 222a-222d in domain 205. The sample clock which lands in the middle of the eye of the alternate 1/0 pattern is then used to sample all of the read data from the memory. Therefore, based on the illustrations of figure 3, clock phase 222a will be selected as the optimal sampling phase because that phase provides points that are farthest away from the edges of the clock. Since an embodiment of the inventive system uses the same flip-flop cell that is used for generating the alternate 1/0 pattern for sampling the read data from the memory, the phase of the alternate 1/0 pattern is virtually identical to the phase of the sampled rise and fall data 304 and 306. Therefore, the optimal clock phase 222a, as shown as 308, needed to sample the alternate 1/0 pattern will be the same as that needed to sample rise and fall data 314 and 316 at the output of flops 214 and 216.

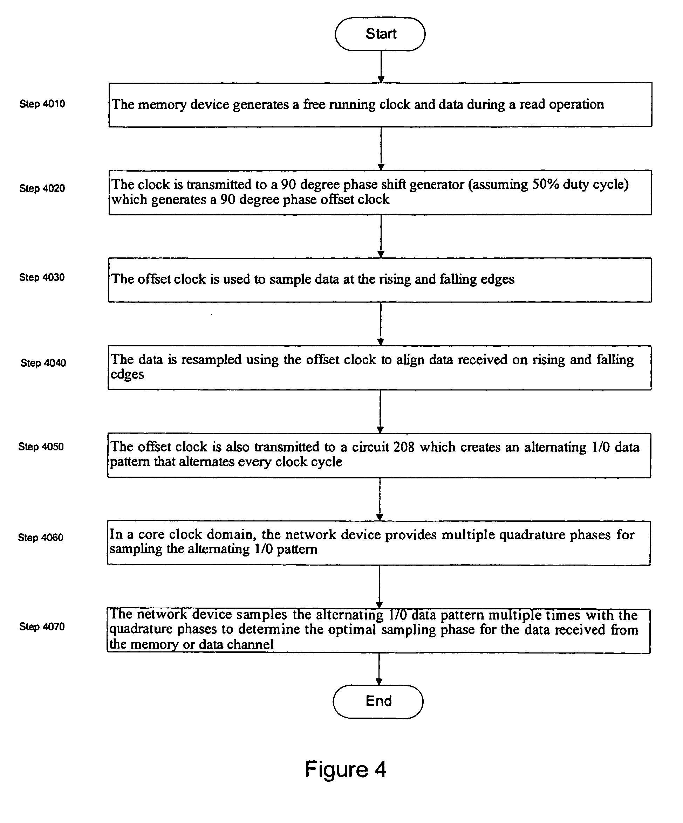

Figure 4 illustrates the steps implemented in transferring timing from a memory clock domain to a core clock domain in order to determine an optimal sampling phase. In Step 4010, during a read operation in memory clock domain 203, memory device 201 generates clock 202 and data 204. In Step 4020, clock 202 is then transmitted to 90 degree phase shift generator 206 which generates 90 degree phase offset clock 207. It should be noted that while the phase shift generator 206 in one embodiment of the invention is a 90 degree phase shift generator, a 90 degree phase shift generator is optional and other phase shift generators may be implemented in the present invention. In Step 4030, clock 207 is used to sample data at the rising and falling edges of clock 207. In Step 4040, the data sampled at the rising and falling edges of the clock 207 are lined up. In Step 4050, clock 207 is also transmitted to divide-by-two circuit 208 which creates an alternating 1/0 data pattern that alternates every clock cycle. In Step 4060, in core clock domain 205, device 100 provides multiple quadrature phases 222a-222d for sampling the alternating 1/0 pattern. In Step 4070, device 100 samples the alternating 1/0 data pattern multiple times with clocks 222a-222d to determine which of the quadrature phases is optimal for resampling the received data.

According to an embodiment, device 100 includes an algorithm for determine which quadrature clock 222a-222d to use in sampling data. The algorithm relies on comparing samples (voting) from clocks 222a-222d of the sampled values from the alternating 1/0 pattern to determine where the edges of the pattern are located. The results of these comparisons create "votes" for selecting one particular phase of sampling clock. According to an embodiment of the invention, the algorithm counts these votes from quadrature clock 222a-222d and only makes changes when the counts pass predetermined thresholds. Specifically, a free running counter is programmable to thresholds of 16, 32 and 64. While the counter is running, a count is taken on how many times a vote is asserted for selecting any particular one of the quadrature clocks 222a-222d. If any count is asserted to a maximum count value, then the device 100 switches to that sampling phase, otherwise it says at the current phase selection. When the data edge occurs coincident with a sampling clock and there are sufficient counts for two different quadrature clocks, then an optimal phase selection point is determined to be 180 degrees from the sampling clock which is aligned with the data bit. The counting of votes for a particular number of clock cycles essentially forms a filtering function which prevents a noise event from causing an erroneous change in the sampling point. Note that the use of an alternating 1/0 patterns for multiphase sampling is preferable to sampling received data because data transition is assured in every clock cycle and votes can be compared with a max count of 16, 32 or 64. According to another embodiment of the invention, the algorithm makes changes immediately upon detecting a more optimal sampling point without accumulating a count of votes.

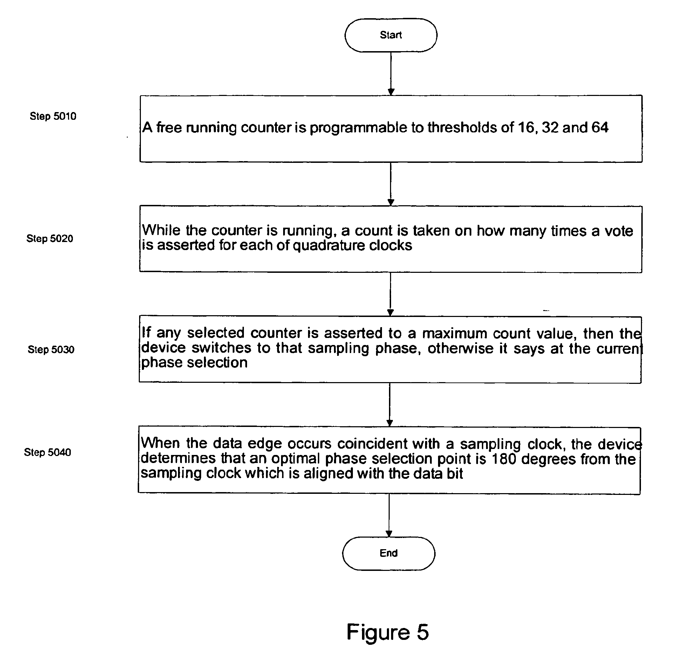

Figure 5 illustrates the steps implemented in determining which quadrature clock 222a-222d to use in sampling data. In Step 5010, a free running counter is programmable to thresholds of 16, 32 and 64. In Step 5020, while the counter is running, counts are taken on how many times votes are asserted for each of the quadrature clocks 222a-222d. In Step 5030, if any count is asserted to a maximum count value, then device 100 switches to that sampling phase, otherwise it says at the current phase selection. In Step 5040, when the data edge occurs coincident with a sampling clock and there are sufficient counts for two different quadrature clocks, device 100 determines that an optimal phase selection point is 180 degrees from the sampling clock which is aligned with the data bit.

The foregoing description has been directed to specific embodiments of this invention. It will be apparent, however, that other variations and modifications may be made to the described embodiments, with the attainment of some or all of their advantages. Therefore, it is the object of the appended claims to cover all such variations and modifications as come within the scope of the invention.

## Claims

1. A network device (100) for determining an optimal sampling phase for source synchronous data (204) received from an external device (201), the network device (100) comprising:
receiving means for receiving from a transmitting device an external device clock (202) and data (204) with a fixed phase relationship;
a phase shifter (206) for phase shifting the external device clock (202);
**characterized by**
a divide-by-two circuit (208) for receiving the phase shifted external device clock (207) and for generating an alternating 1/0 signal pattern (302), which alternates every clock cycle;
means (210, 212) for sampling the data signal in a transmitter clock domain (203) using said phase shifted external device clock, and means for aligning (214, 216) the sampled data with the alternating 1/0 signal pattern (302);
means for generating a plurality of phases (222a, 222b, 222c, 222d) of a core clock, in a core clock domain (205), for sampling the alternating 1/0 signal pattern (302);
selecting means (224) for selecting an optimal phase for sampling the data (314, 316) based on results of sampling the alternating 1/0 signal pattern (302) using the plurality of phases (222a, 222b, 222c, 222d).

2. The network device (100) according to claim 1, wherein the selecting means comprises means for obtaining votes from comparing the results of sampling using the plurality of phases (222a, 222b, 222c, 222d) to determine where a data transition edge is located.

3. The network device (100) according to claim 1, wherein the selecting means comprises means for changing the optimal phase (222a, 222b, 222c, 222d) when a count of votes from the plurality of phases (222a, 222b, 222c, 222d) passes a predetermined threshold.

4. The network device (100) according to claim 1, wherein the selecting means comprises a free running counter that is programmable to at least one threshold.

5. The network device (100) according to claim 4, wherein the selecting means further comprises means for taking a count on how many times a vote is asserted for each of the plurality of phases (222a, 222b, 222c, 222d) while the counter is running, wherein if a maximum count value is reached, the one of the plurality of phases (222a, 222b, 222c, 222d) associated with the count is selected as the optimal sampling phase (222a, 222b, 222c, 222d).

6. A method for determining an optimal sampling phase for source synchronous data (204) received from an external device (201), the method comprising the steps of:
receiving from a transmitting device a external device clock (202) and data (204) with a fixed phase relationship;
phase shifting the external device clock (202),
**characterized by** the steps:
generating an alternating 1/0 signal pattern (302), which alternates every clock cycle, out of the phase shifted external device clock (207) using a divide-by-two circuit (208);
sampling the data signal (304, 306) in a transmitter clock domain (203) using said phase shifted external device clock, and aligning the sampled data with the alternating 1/0 signal pattern (302);
generating a plurality of phases (222a, 222b, 222c, 222d) of a core clock;
sampling the alternating 1/0 signal pattern (302) in a core clock domain (205), with the plurality of phases (222a, 222b, 222c, 222d); and
selecting an optimal phase for sampling the data (314, 316) based on results of sampling the alternating 1/0 signal pattern (302) using the plurality of phases (222a, 222b, 222c, 222d).

7. The method according to claim 6, wherein the step of selecting comprises obtaining votes from comparing the results of sampling using the plurality of phases (222a, 222b, 222c, 222d) to determine where a data transition edge is located.

8. The method according to claim 6, wherein the step of selecting comprises changing the optimal phase (222a, 222b, 222c, 222d) when a count of votes from the plurality of phases (222a, 222b, 222c, 222d) passes a predetermined threshold.

9. The method according to claim 6, wherein the step of selecting comprises programming a free running counter to at least one threshold.

## Patentansprüche

1. Netzwerkvorrichtung (100) zum Ermitteln einer optimalen Abtastphase für mit einer Quelle synchrone Daten (204), die von einer externen Vorrichtung (201) empfangen werden, wobei die Netzwerkvorrichtung (100) Folgendes umfasst:
eine Empfangseinrichtung zum Empfangen, von einer Sendevorrichtung, eines Taktes (202) der externen Vorrichtung und von Daten (204) mit einer festen Phasenbeziehung;
einen Phasenschieber (206) zum Phasenverschieben des externen Vorrichtungstaktes (202);
**gekennzeichnet durch**
eine Halbierschaltung (208) zum Empfangen des phasenverschobenen externen Vorrichtungstaktes (207) und zum Erzeugen eines alternierenden 1/0-Signalmusters (302), das bei jedem Taktzyklus alterniert;
eine Einrichtung (210, 212) zum Abtasten des Datensignals in einer Sendertaktdomäne (203) unter Verwendung des phasenverschobenen externen Vorrichtungstaktes, und
eine Einrichtung zum Abstimmen (214, 216) der abgetasteten Daten auf das alternierende 1/0-Signalmuster (302);
eine Einrichtung zum Erzeugen einer Vielzahl von Phasen (222a, 222b, 222c, 222d) eines Kerntakts in einer Kerntaktdomäne (205) zum Abtasten des alternierenden 1/0-Signalmusters (302);
eine Auswähleinrichtung (224) zum Auswählen einer optimalen Phase für das Abtasten der Daten (314, 316) auf der Basis von Ergebnissen des Abtastens des alternierenden 1/0-Signalsmusters (302) unter Verwendung der Vielzahl von Phasen (222a, 222b, 222c, 222d).

2. Netzwerkvorrichtung (100) nach Anspruch 1, wobei die Auswähleinrichtung eine Einrichtung zum Erhalten von Voten aus dem Vergleich der Ergebnisse des Abtastens unter Verwendung der Vielzahl von Phasen (222a, 222b, 222c, 222d) umfasst, um zu ermitteln, wo sich eine Datenübergangsflanke befindet.

3. Netzwerkvorrichtung (100) nach Anspruch 1, wobei die Auswähleinrichtung eine Einrichtung zum Wechseln der optimalen Phase (222a, 222b, 222c, 222d) umfasst, wenn eine Zählung von Voten aus der Vielzahl von Phasen (222a, 222b, 222c, 222d) einen vorher festgelegten Schwellenwert überschreitet.

4. Netzwerkvorrichtung (100) nach Anspruch 1, wobei die Auswähleinrichtung einen frei laufenden Zähler umfasst, der auf wenigstens einen Schwellenwert programmierbar ist.

5. Netzwerkvorrichtung (100) nach Anspruch 4, wobei die Auswähleinrichtung des Weiteren eine Einrichtung zum Vornehmen einer Zählung dahingehend umfasst, wie oft ein Votum für jede der Vielzahl von Phasen (222a, 222b, 222c, 222d) gesetzt wird, während der Zähler läuft, wobei dann, wenn ein maximaler Zählungswert erreicht wird, die eine der Vielzahl von Phasen (222a, 222b, 222c, 222d), die mit der Zählung assoziiert ist, als die optimale Abtastphase (222a, 222b, 222c, 222d) ausgewählt wird.

6. Verfahren zum Ermitteln einer optimalen Abtastphase für mit einer Quelle synchrone Daten (204), die von einer externen Vorrichtung (201) empfangen werden, wobei das Verfahren die folgenden Schritte umfasst:
Empfangen, von einer Sendevorrichtung, eines Taktes (202) der externen Vorrichtung und von Daten (204) mit einer festen Phasenbeziehung;
Phasenverschieben des externen Vorrichtungstaktes (202), **gekennzeichnet durch** die folgenden Schritte:
Erzeugen eines alternierenden 1/0-Signalmusters (302), welches bei jedem Taktzyklus alterniert, aus dem phasenverschobenen externen Vorrichtungstakt (207) unter Verwendung einer Halbierschaltung (208);
Abtasten des Datensignals (304, 306) in einer Sendertaktdomäne (203) unter Verwendung des phasenverschobenen externen Vorrichtungstaktes; und Abstimmen der abgetasteten Daten auf das alternierende 1/0-Signalmuster (302);
Erzeugen einer Vielzahl von Phasen (222a, 222b, 222c, 222d) eines Kerntakts;
Abtasten des alternierenden 1/0-Signalmusters (302) in einer Kerntaktdomäne (205) mit der Vielzahl von Phasen (222a, 222b, 222c, 222d); und
Auswählen einer optimalen Phase für das Abtasten der Daten (314, 316) auf der Basis von Ergebnissen des Abtastens des alternierenden 1/0-Signalmusters (302) unter Verwendung der Vielzahl von Phasen (222a, 222b, 222c, 222d).

7. Verfahren nach Anspruch 6, wobei der Schritt des Auswählens das Erhalten von Voten aus dem Vergleich der Ergebnisse des Abtastens unter Verwendung der Vielzahl von Phasen (222a, 222b, 222c, 222d) umfasst, um zu ermitteln, wo sich eine Datenübergangsflanke befindet.

8. Verfahren nach Anspruch 6, wobei der Schritt des Auswählens das Wechseln der optimalen Phase (222a, 222b, 222c, 222d) umfasst, wenn eine Zählung von Voten aus der Vielzahl von Phasen (222a, 222b, 222c, 222d) einen vorher festgelegten Schwellenwert überschreitet.

9. Verfahren nach Anspruch 6, wobei der Schritt des Auswählens das Programmieren eines frei laufenden Zählers auf wenigstens einen Schwellenwert umfasst.

## Revendications

1. Dispositif de réseau (100) pour déterminer une phase d'échantillonnage optimale pour des données synchrones de source (204) reçues d'un dispositif externe (201), le dispositif de réseau (100) comprenant :
un moyen de réception pour recevoir d'un dispositif d'émission une horloge de dispositif externe (202) et des données (204) avec une relation de phase fixe ;
un décaleur de phase (206) pour décaler la phase de l'horloge de dispositif externe (202) ;
**caractérisé par**
un circuit de division par deux (208) pour recevoir l'horloge de dispositif externe à décalage de phase (207) et pour générer un motif de signal 1/0 en alternance (302), qui alterne à chaque cycle d'horloge ;
un moyen (210, 212) pour échantillonner le signal de données dans un domaine d'horloge d'émetteur (203) en utilisant ladite horloge de dispositif externe à décalage de phase, et un moyen pour aligner (214, 216) les données échantillonnées avec ledit motif de signal 1/0 en alternance (302) ;
un moyen pour générer une pluralité de phases (222a, 222b, 222c, 222d) d'une horloge de coeur, dans un domaine d'horloge de coeur (205), pour échantillonner le motif de signal 1/0 en alternance (302) ;
un moyen de sélection (224) pour sélectionner une phase d'échantillonnage optimale pour échantillonner les données (314, 316) d'après des résultats d'échantillonnage du motif de signal 1/0 en alternance (302) en utilisant la pluralité de phases (222a, 222b, 222c, 222d).

2. Dispositif de réseau (100) selon la revendication 1, dans lequel le moyen de sélection comprend un moyen pour obtenir des votes à partir de la comparaison des résultats d'échantillonnage en utilisant la pluralité de phases (222a, 222b, 222c, 222d) pour déterminer où se trouve un front de transition de données.

3. Dispositif de réseau (100) selon la revendication 1, dans lequel le moyen de sélection comprend un moyen pour changer la phase optimale (222a, 222b, 222c, 222d) lorsqu'un compte de votes de la pluralité de phases (222a, 222b, 222c, 222d) passe un seuil prédéterminé.

4. Dispositif de réseau (100) selon la revendication 1, dans lequel le moyen de sélection comprend un compteur à fonctionnement libre qui est programmable à au moins un seuil.

5. Dispositif de réseau (100) selon la revendication 4, dans lequel le moyen de sélection comprend en outre un moyen pour tenir un compte du nombre de fois qu'un vote est effectué pour chacune de la pluralité de phases (222a, 222b, 222c, 222d) pendant que le compteur est en fonctionnement, dans lequel, si une valeur de compte maximale est atteinte, l'une de la pluralité de phases (222a, 222b, 222c, 222d) associée au compte est sélectionnée en tant que phase d'échantillonnage optimale (222a, 222b, 222c, 222d).

6. Procédé pour déterminer une phase d'échantillonnage optimale pour des données synchrones de source (204) reçues d'un dispositif externe (201), le procédé comprenant les étapes consistant à :
recevoir d'un dispositif d'émission une horloge de dispositif externe (202) et des données (204) avec une relation de phase fixe ;
décaler la phase de l'horloge de dispositif externe (202) ;
**caractérisé par** les étapes consistant à :
engendrer un motif de signal 1/0 en alternance (302), qui alterne à chaque cycle d'horloge, à partir de l'horloge de dispositif externe à décalage de phase (207) en utilisant un circuit de division par deux (208) ;
échantillonner le signal de données (304, 306) dans un domaine d'horloge d'émetteur (203) en utilisant ladite horloge de dispositif externe à décalage de phase, et aligner les données échantillonnées avec le motif de signal 1/0 en alternance (302) ;
engendrer une pluralité de phases (222a, 222b, 222c, 222d) d'une horloge de cour ;
échantillonner le motif de signal 1/0 en alternance (302) dans un domaine d'horloge de coeur (205) avec la pluralité de phases (222a, 222b, 222c, 222d) ; et
sélectionner une phase optimale pour échantillonner les données (314, 316) d'après des résultats d'échantillonnage du motif de signal 1/0 en alternance (302) en utilisant la pluralité de phases (222a, 222b, 222c, 222d).

7. Procédé selon la revendication 6, dans lequel l'étape de sélection comprend l'obtention de votes à partir de la comparaison des résultats d'échantillonnage en utilisant la pluralité de phases (222a, 222b, 222c, 222d) pour déterminer où se trouve un front de transition de données.

8. Procédé selon la revendication 6, dans lequel l'étape de sélection comprend le changement de la phase optimale (222a, 222b, 222c, 222d) lorsqu'un compte de votes de la pluralité de phases (222a, 222b, 222c, 222d) passe un seuil prédéterminé.

9. Procédé selon la revendication 6, dans lequel l'étape de sélection comprend la programmation d'un compteur à fonctionnement libre à au moins un seuil.
